# EUROPEAN PATENT SPECIFICATION

(11) **EP 1 840 244 B1**
(45) Date of publication and mention of the grant of the patent: **26.09.2012**
(21) Application number: 05816844.4
(22) Date of filing: 15.12.2005
(51) Int. Cl.: C23C 24/08, B22F 9/12, B22F 9/24, H01B 5/14, H01B 13/00, C23C 26/00

(54) **METHOD FOR FORMING METAL THIN FILM, AND METAL THIN FILM**
VERFAHREN ZUR BILDUNG EINES DÜNNEN METALLFILMS UND DÜNNER METALLFILM
PROCÉDÉ DE FORMATION D'UN MINCE FILM MÉTALLIQUE ET MINCE FILM MÉTALLIQUE

(30) Priority: 20.12.2004 JP 2004367554
(43) Date of publication of application: 03.10.2007
(73) Proprietor: ULVAC, INC., Chigasaki-shi, Kanagawa 253-8543 (JP); Jemco Inc., Akita-shi, Akita 010-8585 (JP)
(72) Inventor: ATSUKI, Tsutomu, Chiba 2891226 (JP); TEI, Kyuukou, Chiba 2891226 (JP); ODA, Masaaki, Chiba 2891226 (JP)
(74) Representative: AMMANN PATENTANWÄLTE AG BERN
(86) International application number: PCT/JP2005/023009
(87) International publication number: WO 2006/068019

(56) References cited:
- EP-A1- 1 184 898
- EP-A1- 1 199 123
- WO-A1-01/68596
- WO-A1-03/106573
- WO-A2-2004/052559
- JP-A- 2000 124 157
- JP-A- 2000 124 157
- JP-A- 2001 234 355
- JP-A- 2001 234 355
- JP-A- 2002 299 833
- US-A- 5 882 722
- US-A1- 2003 180 451
- US-B1- 6 190 731

## Description

### Technical Field.

The present invention relates to a conductive metal thin film-forming method which makes use of metal nanoparticles.

### Background Art

There has been proposed a method for forming a conductive coating film using a metal colloidal solution as a method for forming an electrode at a low temperature (see, for instance, Japanese Un-Examined Patent Publication 2004-207558 (Claim 1, Section Nos. 0049 to 0050)). In this case, the method is one for forming a conductive coating film by applying a metal colloidal solution onto the surface of a base material or a substrate according to the ink jet printing technique, wherein the substrate used in the application of the coating film is one provided thereon with a layer for receiving ink jet printing ink and the drying step is carried out at a temperature of not more than 100°C, after the completion of the coating operation. According to this method, a coated film formed on a sheet of paper specially designed for the ink jet printing as a substrate has a low volume resistivity, after the drying of the same, on the order of 4.5×10⁻⁶Ω · cm, but a coated film formed on a sheet of the usual paper for making a copy (i. e. the usual photocopying paper) which is free of any coating layer has a high surface resistance value on the order of not less than 1.0× 0×10⁸Ω/□ (this value can be converted into the volume resistivity of not less than 4.5 × 10⁷ µ Ω · cm on the basis of the film thickness of 450 nm). Accordingly, the use of such a layer for receiving ink jet printing ink should be required for the reduction of the resistance of the coated film.

In addition, there have also been proposed a reducing method (see, for instance, Japanese Patent Application Serial No. 2003-317161 (Japanese Un-Examined Patent Publication 2005-081501)) and the gaseous phase evaporation technique (see, for instance, Japanese Un-Examined Patent Publication 2002-121606 (Claim 6)) as methods for preparing metal nanoparticles.

According to EP-A-1 184 898, a liquid dispersion of a metal-containing organic compound is applied to a surface and dried. The organic compound is decomposed by irradiation by an energy beam, e.g. an electron beam.

US-6,190,731 proposes to produce a colloidal metal ink containing metal particles encapsulated by organic compounds. A metallic deposit is obtained by heating the applied and dried ink to a high temperature, e.g. 180 °C, or in an IR oven.

US-5,882,722 discloses a thick film obtained from a mixture of metal powders and metallo-organic decomposition (MOD) compounds. The decomposition occurs at temperatures as high as 200 °C with completion at temperatures not exceeding 450 °C.

EP-A-1 199 123 proposes composite metallic ultrafine particles. The particles consist of a metal core produced e.g. from a metallic salt. The surface of the particles is covered with an organic compound. A liquid dispersion of the particles is applied to a surface, dried by spin-drying, and baked at a temperature of from 200 °C up to 350 °C.

### Disclosure of the Invention

### Problems That the Invention is to Solve

In the methods for forming thin films which have been used as distributing wires or electrical connections in the field of the electric and electronic industries, the film-forming temperature used therein has gradually been reduced recently. In addition, as a base material used for forming a thin film thereon by applying metal nanoparticles onto the same, drying the applied nanoparticles and firing the same, there have been used various kinds of base materials such as glass, polyimide, PET films, PEN films, and polycarbonate. In addition to the methods which make use of these base materials, metal nanoparticles have been sometimes applied onto a substrate or a glass plate provided thereon with TFT (thin film transistors) and accordingly, there has been desired for the reduction of the film-forming temperature (firing temperature). The firing temperature may vary depending on the characteristic properties of the base material selected, but it has been desired for the firing of the same even at a temperature of not more than 200°C in certain cases.

In consideration of these conditions, it has strongly been desired for the formation of a thin film having a desired thickness, while making use of a firing step carried out at a low temperature and reducing the number of coating steps or film-forming steps without using any heat-treatment carried out at a high temperature. To this end, there has been desired for the development of a method for forming a thin film having a low resistivity, while making use of a dispersion of metal nanoparticles having a high metal content, without using any heat-treatment carried out at a high temperature.

Up to now, when forming a metal nanoparticle-containing thin film used in such applications, various problems arise such that the method requires the use of a high temperature firing step although the resistivity of the resulting film can be reduced; and that the method permits the use of a low temperature treatment, but it leads to an increase in the number of coating steps. In this respect, if the solid content of the coating solution is increased by any means to reduce the number of coating steps, however, problems newly arise such that the resulting coating solution is quite instable and this results in the occurrence of a secondary aggregation to thus cause the settlement of metal particles.

Accordingly, it is an object of the present invention to solve the foregoing problems associated with the conventional techniques and, more specifically, to provide a method for forming a conductive metal thin film, using metal nanoparticles, on a substrate free of any layer for receiving ink jet printing ink on the surface thereon, unlike such a substrate as the paper specially designed for the ink jet printing (i.e. a substrate provided thereon with a layer for receiving the ink jet printing ink), which is provided thereon with a thin film-receiving layer, which can eliminate the use of any heat-treatment carried out at a high temperature, and to likewise provide a metal thin film.

### Means for Solving the Problems

The metal thin film-forming method according to the present invention comprises the step of firing metal nanoparticles which comprise particles consist of at least one metal selected from the group consisting of Ag, Au, Ni, Pd, Rh, Ru, and Pt or an alloy comprising at least two of these metals and an organic substance adhered to the periphery of the metal or alloy as a dispersant, wherein the firing step is carried out under a gas atmosphere containing an organic acid or both water and an organic acid. The use of such a firing atmosphere would be able to form a metal thin film having a low resistivity value.

The foregoing organic acids are preferably saturated fatty acids or unsaturated fatty acids having not more than 4 carbon atoms. In this connection, if the number of carbon atoms of each organic acid exceeds 4, various problems arise such that the resistance value of the resulting thin film is not reduced even when the film is fired and that an offensive odor is generated during the firing operation.

Moreover, the metal thin film according to the present invention is characterized in that it is formed according to the foregoing metal thin film-forming method.

### Effects of the Invention

The present invention permits the achievement of such an effect that a conductive metal thin film having a low resistance value can be formed, using conductive metal nanoparticles, on a substrate free of any layer for receiving ink jet printing ink on the surface thereof, unlike such a substrate as the paper specially designed for the ink jet printing, which is provided thereon with such receiving layer, the thin film being prepared by a heat-treatment, at a low temperature, within a gas atmosphere containing an organic acid or both water and an organic acid without using any heat-treatment carried out at a high temperature.

### Best Mode for Carrying Out the Invention

According to the present invention, the metal constituting the metal nanoparticles used in the invention is at least one member selected from the group consisting of conductive metals such as Ag, Au, Ni, Pd, Rh, Ru, and Pt or an alloy comprising at least two of these metals and it may properly be selected depending on the purposes and/or applications of the resulting thin film. In the following description, the term "metal" used also includes the alloys thereof. The nanoparticles constituted by the foregoing metals each have such a structure that an organic substance is adhered to the circumference or periphery of each nanoparticle as a dispersant. The term "adhered to, adhesion or the like" herein used means that an organic substance is adsorbed on the surface of a metal nanoparticle through a metal ion in such a manner that the organic substance would assist the stable dispersion of metal particles in an organic dispersion medium.

The foregoing organic substance is at least one member selected from the group consisting of fatty acids and amines.

The fatty acid may preferably be at least one member selected from the group consisting of saturated fatty acids and unsaturated fatty acids each having a linear or branched structure and each having 6 to 22 carbon atoms. In this respect, if the fatty acid has less than 6 carbon atoms, the resulting dispersion is quite unstable and it is quite liable to undergo agglomeration and therefore, it would be impossible to increase the metal concentration of the dispersion. On the other hand, if the number of carbon atoms present in the fatty acid molecule exceeds 22, problems would arise such that the viscosity of the resulting dispersion increases and this in turn results in the reduction of the handling properties of the dispersion when increasing the metal concentration of the metal nanoparticle-containing dispersion and that carbon atoms are liable to remain in the thin film finally obtained after the firing step and this in turn leads to an increase in the specific resistance value of the resulting film.

As the foregoing fatty acids, there may be listed, for instance, hexanoic acid, heptanoic acid, octanoic acid, nonanoic acid, decanoic acid, undecanoic acid, dodecanoic acid, tetradecanoic acid, hexadecanoic acid, octadecanoic acid, eicosanoic acid, docosanoic acid, 2-ethylhexanoic acid, oleic acid, linolic acid and linolenic acid.

The foregoing amine is desirably at least one member selected from the group consisting of aliphatic amines each having a linear or branched structure and each having 6 to 13 carbon atoms. In this connection, if the amine has less than 6 carbon atoms, the following problem arises: there is observed such a tendency that the basic properties of the amine are too strong to thus corrode metal nanoparticles and the amine may finally dissolve the metal nanoparticles. On the other hand, if the number of carbon atoms present in the main chain of the alkylamine exceeds 13, problems would arise such that the viscosity of the resulting dispersion increases and this in turn results in the reduction of the handling properties of the dispersion when increasing the metal concentration of the metal nanoparticle-containing dispersion and that carbon atoms are liable to remain in the thin film finally obtained after the firing step and this in turn leads to an increase in the specific resistance value of the resulting film.

The foregoing aliphatic amine is desirably a primary, secondary or tertiary alkylamine, but it may likewise be a polyvalent amine such as a monoamine, a diamine or a triamine.

Specific examples of such alkylamines include primary amines such as butylamine, hexylamine, heptylamine, n-octylamine, nonylamine, decylamine, dodecylamine, hexa-dodecylamine, 2-ethylhexylamine, 1,3-dimethyl-n-butylamine, 1-amino-undecane and 1-amino-tridecane; secondary amines such as di-n-butylamine, di-n-propylamine, di-isopropylamine, N-methylaniline, di-isobutylamine, di-pentylamine, and di-hexylamine; and tertiary amines such as dodecyl-dimethylamine, N,N-dibutyl-1-butaneamine, N,N-dimethyl-butylamine, N,N-dimethyl-hexylamine, and N,N-dimethyl-octylamine; as well as diamines such as naphthalene-diamine, octamethylene-diamine, and nonane-diamine. Among these amines, preferably used herein are hexylamine, heptylamine, n-octylamine, decylamine, dodecylamine, 2-ethylhexylamine, 1,3-dimethyl-n-butyl-amine, 1-amino-undecane and 1-amino-tridecane.

In the present invention, the firing of the metal nanoparticles is carried out in a gas atmosphere containing an organic acid or both water and an organic acid and the firing step is not carried out at a high temperature, but at a low temperature. This organic acid is a saturated fatty acid or unsaturated fatty acid having not more than 4 carbon atoms and specific examples thereof include saturated fatty acids such as formic acid, acetic acid, propionic acid, n-butyric acid and iso-butyric acid; and unsaturated fatty acids such as acrylic acid, methacrylic acid, crotonic acid, isocrotonic acid, maleic acid and fumaric acid. It is sufficient in the present invention that the ratio of water to be mixed with an organic acid may range from (0 to 100): (100 to 0) as expressed in the unit of "% by mass". In addition, the gas to be mixed with water and/or the organic acid may be air, oxygen, or an inert gas such as nitrogen gas, but the ratio of the foregoing gas is not restricted to any specific range. According to the present invention, it is possible to form a metal thin film having a low resistance value. Moreover, the firing temperature is in general not less than 50°C, preferably not less than about 80°C and this would allow the formation of a thin film having a satisfactory and practically acceptable specific resistance value. It is sufficient to appropriately set the upper limit of the firing temperature at a proper level while taking into consideration, for instance, the kind of each particular substrate selected.

The method for the preparation of the metal nanoparticles is not likewise restricted to any particular one and specific examples thereof are the reducing method such as that disclosed in Japanese Patent Application Serial No. 2003-317161 (Japanese Un-Examined Patent Publication 2005-081501)) and the gaseous phase evaporation technique disclosed in Japanese Un-Examined Patent Publication 2002-121606.

For instance, such a reducing method comprises the steps of dissolving at least one member selected from the group consisting of metal compounds of the foregoing fatty acids and amines in a non-polar solvent and then subjecting the resulting solution to a reducing treatment by the addition of a reducing agent to thus form metal nanoparticles.

As the foregoing reducing agents, preferably used herein include, for instance, sodium boron hydride, dimethylamine borane, and tertiary butylamine borane. The reducing agents usable herein are not restricted to these specific examples, but may be other known reducing agents insofar as they can show the same reducing action observed for the foregoing specific examples. This reducing reaction may likewise be carried out while introducing, into the reaction system, hydrogen gas, carbon monoxide gas, a hydrogen-containing gas and/or a carbon monoxide gas-containing gas.

The foregoing reducing treatment is preferably carried out under such a condition that the reaction system is subjected to a bubbling treatment while stirring the same, and/or refluxing the reaction system at room temperature or with heating.

As has been described above, the foregoing metal compound is subjected to a reducing treatment in a non-polar solvent to thus form metal colloidal particles in the present invention, but impurities or contaminants (such as boron atoms included in the reducing agent) are present in the reaction liquid. For this reason, deionized water is added to the reaction liquid and then the resulting mixture is stirred, followed by allowing the mixture to stand for a predetermined time period to thus recover the supernatant. Among the impurities present in the reaction liquid, hydrophilic ones are transferred to the aqueous phase at this stage and this accordingly permits the reduction of the content of impurities in the reaction liquid. In this respect, a polar solvent having the smaller number of carbon atoms may be substituted for the deionized water. In addition, the reaction liquid treated as described above can be concentrated through filtration, for instance, ultrafiltration to thus remove the excess fatty acids, fatty acid esters and/or amines and to thus increase the purity and the metal concentration of the resulting product. As a result, a dispersion can be obtained, which comprises metal nanoparticles in a concentration of not less than 5% by mass and not more than 90% by mass.

The non-polar solvent described above and preferably used herein may be, for instance, an organic solvent whose main chain includes 6 to 18 carbon atoms and which has a low polarity. If using an organic solvent whose main chain includes less than 6 carbon atoms, the polarity of the solvent is high to ensure the formation of a desired dispersion or the resulting dispersion suffers from a problem concerning the handling properties and this is because, the coated layer thereof would be dried within an extremely short period of time. On the other hand, if the number of carbon atoms included in the main chain of such an organic solvent exceeds 18, a problem arises such that carbon atoms are liable to remain in the resulting film during the firing step due to possible increases of, for instance, the viscosity of the liquid and/or the boiling point thereof. As such solvents, usable herein include, for instance, long chain alkanes such as hexane, heptane, octane, decane, undecane, dodecane, tridecane and trimethyl pentane; cyclic alkanes such as cyclohexane, cycloheptane and cyclooctane; aromatic hydrocarbons such as benzene, toluene, xylene, trimethyl benzene and dodecyl benzene; and alcohols such as hexanol, heptanol, octanol, decanol, cyclohexanol and terpineol. These solvents may be used alone or in the form of a mixed solvent. For instance, the solvent may be mineral spirit which is a mixture of long chain alkanes.

Moreover, as the gaseous phase evaporation method, an example thereof includes one which comprises the steps of evaporating a metal in a vacuum atmosphere in the presence of the vapor of an organic solvent comprising at least one known organic solvent used for forming metal nanoparticles according to the gaseous phase evaporation method or in the presence of a mixed vapor comprising the vapor of such an organic solvent and the vapor of at least one member selected from the group consisting of, for instance, fatty acids and amines serving as a dispersant to thus bring the metal vapor into close contact with the vapor of the organic solvent or the mixed vapor; cooling the resulting gaseous mixture; and recovering the metal nanoparticles to thus give a liquid containing the metal nanoparticles or a desired dispersion thereof. In this respect, when bringing the metal vapor into contact with only the organic solvent vapor, it is also possible to obtain a desired dispersion by the addition of at least one member selected from the group consisting of, for instance, fatty acids and amines serving as a dispersant to the recovered liquid containing the metal nanoparticles. The method comprising the foregoing steps would permit the formation of a metal nanoparticle-containing dispersion in which metal nanoparticles each having a particle size of not more than 100 nm are separately or individually dispersed.

When bringing the metal vapor into contact with only the organic solvent vapor in the foregoing gaseous phase evaporation technique, a polar solvent having a low molecular weight used for the removal of the organic solvent may be added to the resulting metal nanoparticle-containing dispersion to thus precipitate the metal nanoparticles, after the addition of at least one member selected from the group consisting of, for instance, fatty acids and amines serving as a dispersant to the liquid containing the metal nanoparticles recovered through cooling, followed by the removal of the supernatant to thus substantially remove the organic solvent and the subsequent addition, to the resulting precipitates, of at least one solvent for ensuring the solvent-solvent exchange to thus form a dispersion in which the metal nanoparticles thus precipitated are separately or individually dispersed. On the other hand, when bringing the metal vapor into close contact with the mixed vapor, the polar solvent having a low molecular weight used for the removal of the organic solvent may be added to the liquid containing the metal nanoparticles recovered through cooling to thus precipitate the metal nanoparticles, followed by the removal of the supernatant to thus substantially remove the organic solvent and the subsequent addition, to the resulting precipitates, of at least one solvent for ensuring the solvent-solvent exchange to thus form a dispersion in which the metal nanoparticles thus precipitated are separately or individually dispersed.

The foregoing polar solvent having a low molecular weight is a solvent having the small number of carbon atoms and specific examples thereof preferably used herein are methanol, ethanol and acetone.

The substrate onto which the metal nanoparticles can be applied according to the method of the present invention may appropriately be selected while taking into consideration the purposes and applications of the resulting thin film and examples thereof include a variety of substrates such as glass substrates; resin substrates made of, for instance, polyimide, PET films, PEN films and polycarbonate; and substrates such as glass plates provided thereon with TFT layers. The methods for applying a metal nanoparticle-containing dispersion onto such a substrate are not restricted to specific ones and they may be the spin-coating technique and the ink jet printing technique.

The present invention will hereunder be described in more specifically with reference to the following Examples.

### Example 1

In this Example, Ag was selected as a metal material and the metal nanoparticles used herein were Ag nanoparticles comprising octanoic acid having 8 carbon atoms and 2-ethylhexylamine having 8 carbon atoms, both adhered to the periphery of these Ag nanoparticles. These Ag nanoparticles were dispersed in toluene and the dispersion had a metal concentration of 40% by mass. The Ag nanoparticles used herein were prepared according to the gaseous phase evaporation method.

This Ag nanoparticle-containing dispersion was applied onto the surface of a glass substrate according to the usual spin-coating technique to thus form a film, followed by firing the same at 120°C for 30 minutes in an atmosphere formed by evaporating a water: formic acid mixed liquid [90: 10 (% by mass)] in the air. After the completion of the firing step, the surface of the resulting thin film had a gloss tinged with silver. The specific resistance of the resulting film was determined using Low resistance measurement unit (available from Mitsubishi Chemical Co., Ltd.) and the measurement was carried out for three points on the thin film. In this respect, the surface resistance values were determined, and then the thickness of the thin film was determined for converting the same into the corresponding specific resistance. The results thus obtained are summarized in the following Table 1.

**(Table 1)**

| Surface Resistance (Ω/□) | Film Thickness (*µ* m) | Specific Resistance (Ω • cm) |
|---|---|---|
| 0.1228 | 0.37 | 4.54 x 10⁻⁶ |
| 0.1106 | 0.37 | 4.09 x 10⁻⁶ |
| 0.1228 | 0.37 | 4.54 x 10⁻⁶ |

The data listed in the foregoing Table 1 clearly indicate that the specific resistance of the resulting Ag nanoparticle-containing thin film is nearly equal to that observed for the pure Ag (1.59 × 10⁻⁶ Ω · cm).

### Example 2

The same procedures used in Example 1 were repeated except that the firing temperature was set at 80°C to thus form a thin film and then the electric characteristic properties of the resulting thin film were determined under the same conditions used in Example 1. The results thus obtained are summarized in the following Table 2.

**(Table 2)**

| Surface Resistance (Ω/□) | Film Thickness (*µ* m) | Specific Resistance (Ω · cm) |
|---|---|---|
| 0.2020 | 0.28 | 5.66 x 10⁻⁶ |
| 0.1863 | 0.28 | 5.22 x 10⁻⁶ |
| 0.1885 | 0.28 | 5.28 x 10⁻⁶ |

The data listed in the foregoing Table 2 clearly indicate that the specific resistance of the resulting Ag nanoparticle-containing thin film is slightly greater than that observed for the thin film prepared in Example 1, but the thin film still has a specific resistance value on the order of 10⁻⁶Ω · cm, even when the firing temperature was reduced.

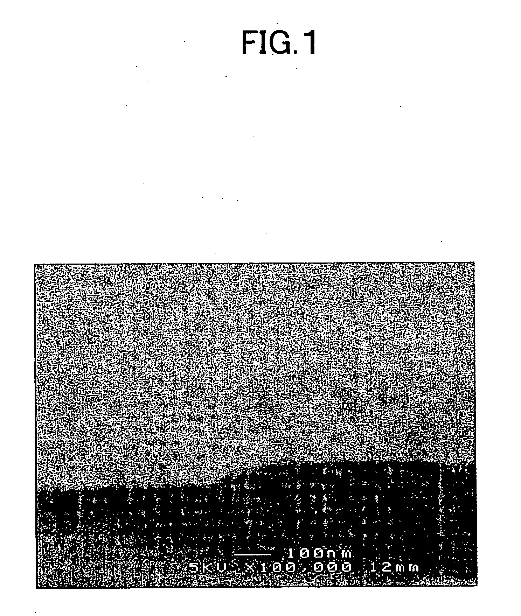

Fig. 1 shows an SEM image illustrating the cross-sectional view of the Ag thin film obtained after the firing step carried out at 80°C and prepared in Example 2. As will be seen from this figure, it can be confirmed that particles are partially sintered in the resulting film.

The results obtained in the following Examples 3 to 18 and Comparative Examples 1 to 12 are summarized in the following Tables 3 and 4. In Examples 3 to 18, the same procedures used in Example 1 were repeated except that the metal species, dispersants and firing conditions used were variously changed to thus form thin films of these Examples and then the electric characteristic properties of the resulting thin films were likewise determined or evaluated under the same conditions used in Example 1. In this connection, the mixing ratio of water to formic acid or acetic acid was set at a level of 90:10 (% by mass) and it was evaporated in the air, but the concentration in the resulting atmosphere was not particularly controlled. Moreover, in Comparative Examples 1 to 12, the same procedures used in Example 1 were repeated except that the firing step was carried out in an atmosphere simply comprising the air and then the electric characteristic properties of the resulting thin films were likewise determined or evaluated under the same conditions used in Example 1.

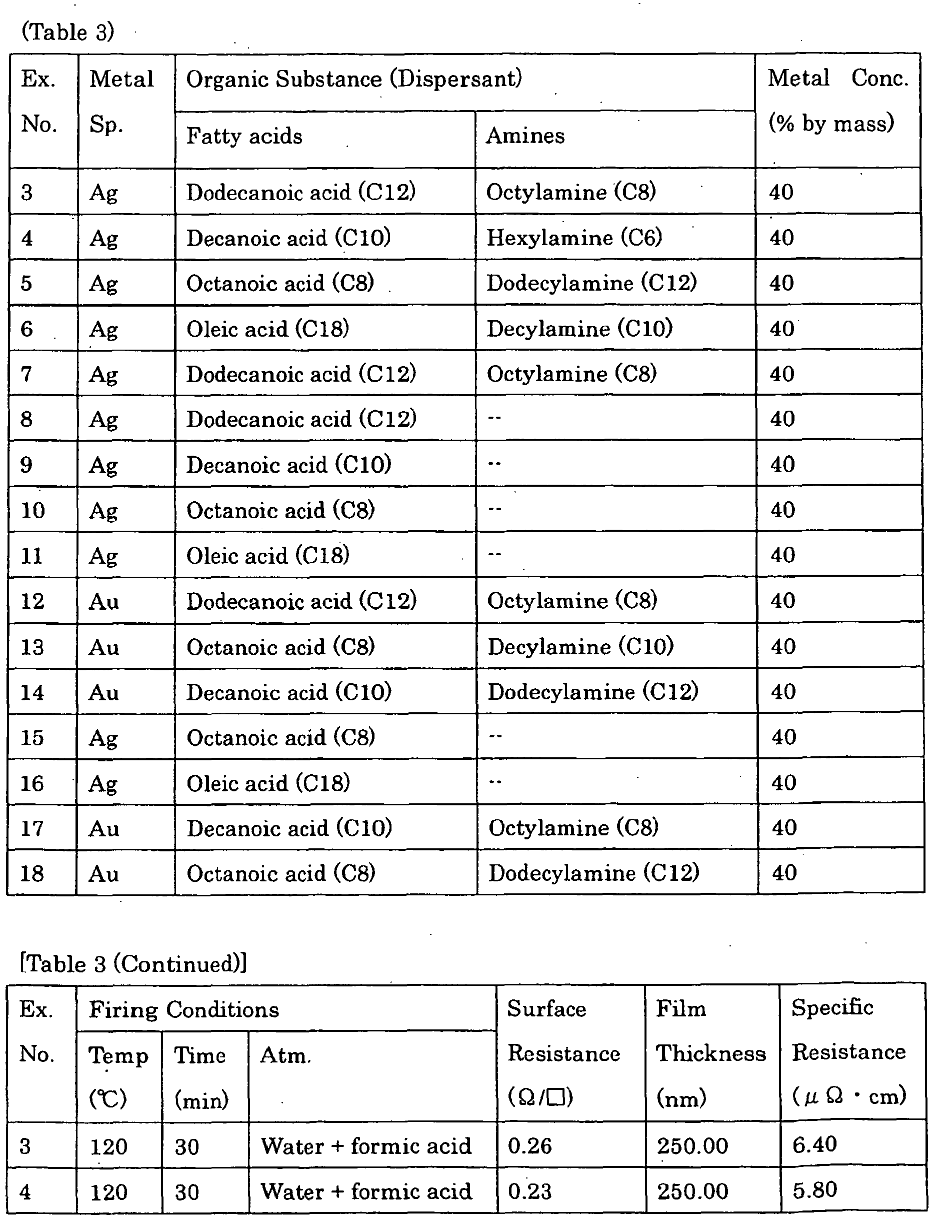

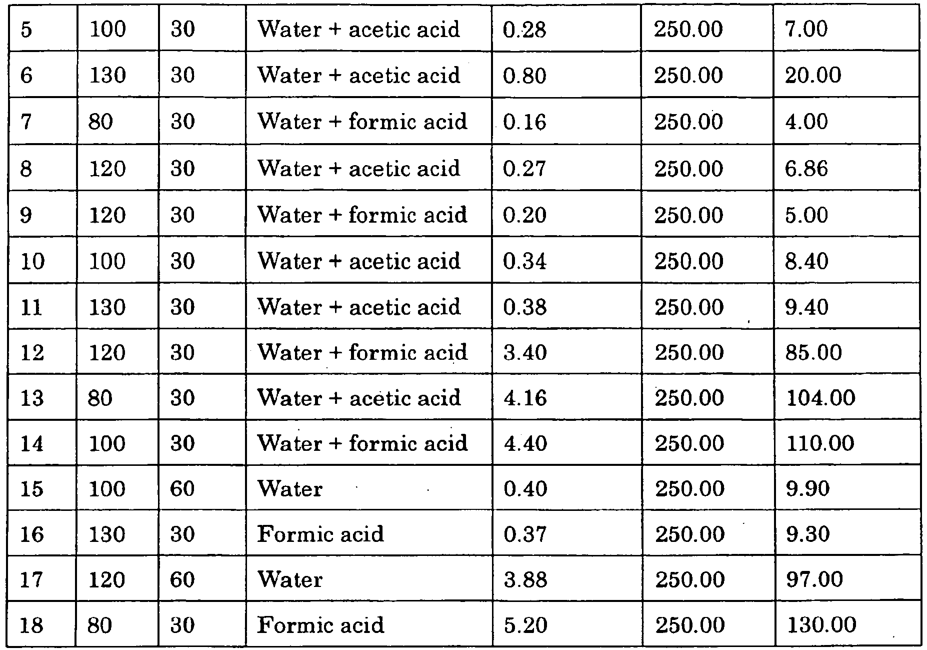

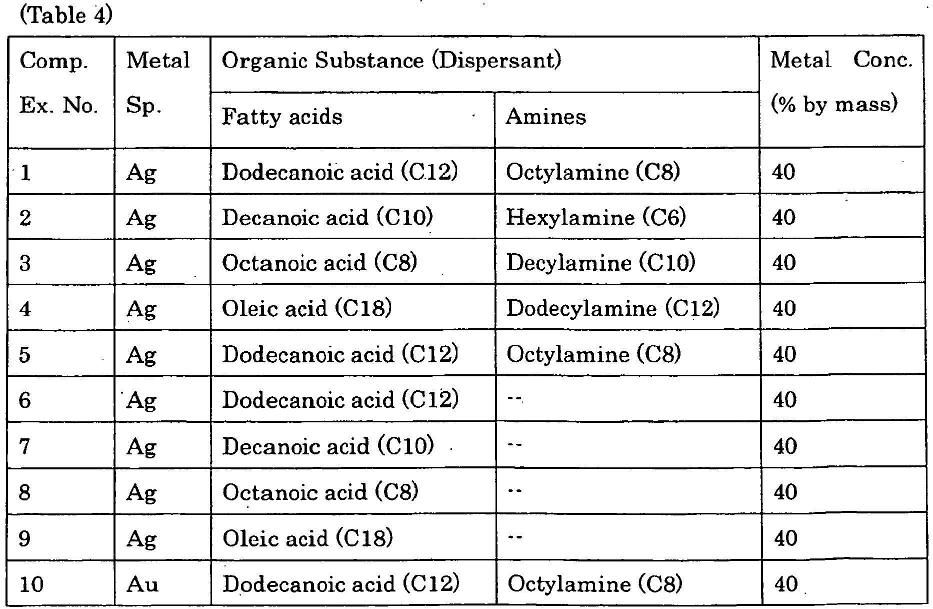

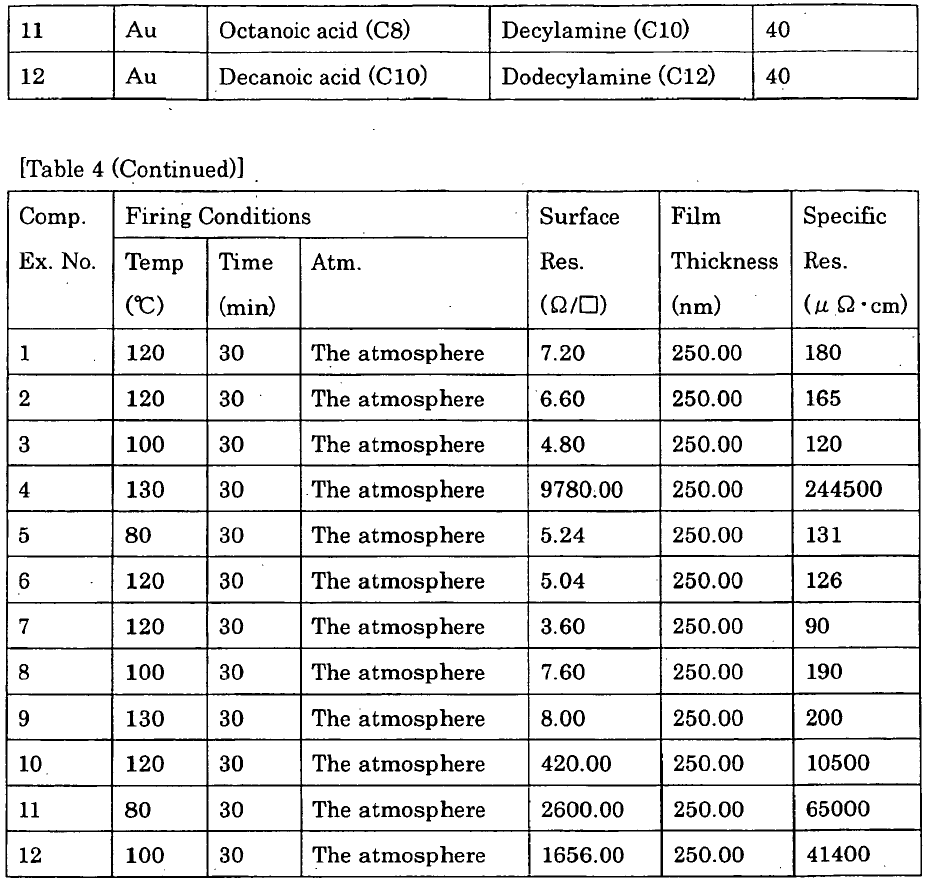

The data listed in the foregoing Tables 3 and 4 indicate that the firing in the atmosphere containing either or both of water and an organic acid can form a thin film having a resistance value lower than that observed for the thin film formed through the use of a firing step carried out in an atmosphere comprising the simple air, under the same temperature condition.

Moreover, even when using the foregoing conductive metals other than Ag and Au as the foregoing metal species, and even when using dispersants selected from the foregoing fatty acids and amines other than those used in the foregoing Examples, one can prepare metal thin films each having a low resistance value similar to those observed for the foregoing Examples.

### Industrial Applicability

The present invention can provide a metal thin film having a sufficient and practically acceptable specific resistance by making use of the low temperature firing treatment carried out under the presence of and optionally water an organic acid. Accordingly, the present invention can effectively be used in or applied to the fields, which require the formation of metal thin films at a low temperature, for instance, in the fields of electric and electronic industries. For instance, the present invention can be applied to the formation of metal distributing wires or metal electrical connections used in the fields of display machinery and tools such as flat panel display devices and in the fields of printed wirings.

### Brief Description of the Drawings

[Figure 1] Fig. 1 shows an SEM image illustrating the cross-sectional view of the Ag thin film prepared in Example 2.

## Claims

1. A conductive metal thin film-forming method which comprises firing metal nanoparticles each comprising a particle consisting of at least one metal selected from the group consisting of Ag, Au, Ni, Pd, Rh, Ru, and Pt or an alloy comprising at least two of these metals and at least one organic substance selected from a fatty acid having 6 to 22 carbon atoms and an amine having 6 to 13 carbon atoms which is adhered to the periphery of the metal or alloy as a dispersant wherein the metal nanoparticles are formed on a substrate free of any layer for receiving ink jet printing ink on the surface thereof and the firing step is carried out under a gas atmosphere containing a fatty acid having not more than 4 carbon atoms or both water and a fatty acid having not more than 4 carbon atoms and at a low temperature not less than 50 °C and not exceeding 130 °C.

2. The conductive metal thin film-forming method of claim 1, **characterized in that** the amine is an aliphatic amine.

## Patentansprüche

1. Verfahren zur Bildung eines dünnen leitenden Metallfilms, welches das Brennen von Metall-Nanopartikeln beinhaltet, die jeweils ein Partikel aus mindestens einem Metall aus der Gruppe bestehend aus Ag, Au, Ni, Pd, Rh, Ru, und Pt oder einer Legierung aus mindestens zwei dieser Metalle enthalten und mindestens einen organischen Stoff ausgewählt aus einer Fettsäure mit 6 bis 22 Kohlenstoffatomen und einem Amin mit 6 bis 13 Kohlenstoffatomen, der an der Peripherie des Metalls oder der Legierung als Dispergiermittel anhaftet, wobei die Metall-Nanopartikel auf einem Substrat ohne eine Schicht zur Annahme von Tintenstrahldrucktinte auf dessen Oberfläche gebildet werden und der Brennschritt unter einer Gasatmosphäre, die eine Fettsäure mit nicht mehr als 4 Kohlenstoffatomen oder sowohl Wasser als auch eine Fettsäure mit nicht mehr als 4 Kohlenstoffatomen enthält, und bei einer niedrigen Temperatur nicht unter 50 °C und nicht über 130 °C erfolgt.

2. Verfahren zur Bildung eines dünnen leitenden Metallfilms nach Anspruch 1, **dadurch gekennzeichnet, dass** das Amin ein aliphatisches Amin ist.

## Revendications

1. Procédé de formation d'un film mince métallique conducteur, qui comprend la cuisson de nanoparticules métalliques comprenant chacune une particule constituée d'au moins un métal choisi parmi le groupe comprenant Ag, Au, Ni, Pd, Rh, Ru et Pt ou d'un alliage comprenant au moins deux de ces métaux et au moins une substance organique choisie parmi un acide gras ayant 6 à 22 atomes de carbone et une amine ayant 6 à 13 atomes de carbone, qui adhère à la périphérie du métal ou de l'alliage en tant que dispersant, où les nanoparticules sont formées sur un substrat libre de toute couche destinée à recevoir de l'encre d'impression par jet d'encre sur sa surface, et l'étape de la cuisson est effectuée sous une atmosphère contenant un acide gras n'ayant pas plus que 4 atomes de carbone ou à la fois de l'eau et un acide gras n'ayant pas plus que 4 atomes de carbone et à une température basse non inférieure à 50 °C et ne dépassant pas 130 °C.

2. Procédé de formation d'un film mince métallique conducteur selon la revendication 1, **caractérisé en ce que** l'amine est une amine aliphatique.
